# EUROPEAN PATENT APPLICATION

(11) **EP 4 658 050 A1**
(43) Date of publication of application: **03.12.2025**
(21) Application number: 24386061.6
(22) Date of filing: 30.05.2024
(51) Int. Cl.: H10N 30/80, G01S 7/4912, G01S 17/06, G01S 17/58, H01S 5/00, H01S 5/026, H01S 5/183

(54) **TRANSDUCER DEVICE, TRANSDUCER MODULE AND METHOD OF OPERATING A TRANSDUCER DEVICE**

(71) Applicant: ams-OSRAM International GmbH, 93055 Regensberg (DE)
(72) Inventor: Colzi, Giacomo, 8803 Rüschlikon (CH); D'Aleo, Francesco, 8833 Samstagern (CH); Grimau, Marcelli, 8134 Adliswil (CH); Katsikatsos, Giorgos, 8037 Zürich (CH); Sánchez, Javier Miguel, 8046 Zürich (CH)
(74) Representative: Epping - Hermann - Fischer

(57) **Abstract**

A transducer device (1) comprising a piezoelectric material (2) is specified, wherein
- the transducer device comprises a detector module (3);
- the detector module (3) comprises an emitter (31) configured to emit a radiation (99);
- the piezoelectric material (2) is transmissive to the radiation (99);
- the detector module (3) is configured to direct the radiation onto a surface (20) of the piezoelectric material (2); and
- the detector module (3) is configured to detect a displacement (200) of the surface (20) based on a part of the radiation (99) that is reflected or scattered back to the detector module (3).

Further, a transducer module (10) and a method of operating a transducer device (1) are specified.

## Description

The present application relates to a transducer device, to a transducer module, and to a method of operating a transducer device.

Piezoelectric materials can be used for various applications such as actuators.

However, piezoelectric materials have non-linear characteristics with hysteretic behaviour. External sensors may be attached to the piezoelectric device to provide a feedback to a control loop so that a closed loop operation is enabled. However, such sensors are bulky and cannot be used in thin-film piezo material applications.

It is an object to provide a way to facilitate an accurate and reliable operation of devices relying on piezoelectric materials.

This object is achieved, inter alia, by a transducer device, a transducer module, and a method according to the independent claims. Further developments and configurations are the subject of the dependent claims.

A transducer device comprising a piezoelectric material is specified.

The transducer device may be any device that takes advantage of the piezoelectric effect to convert electrical energy into mechanical energy or vice versa. By applying an electrical voltage to the piezoelectric material a surface of the piezoelectric material may be displaced with respect to an idle position. Alternatively, or in addition, a mechanical force acting on the surface may result in an electrical signal. The idle position of the surface of the piezoelectric material is the position of the surface in a state where neither an electrical voltage nor a mechanical force is applied to the piezoelectric material.

According to at least one embodiment of the transducer device, the transducer device comprises a detector module.

In particular, the detector module is configured to optically detect a displacement of a surface of the piezoelectric material with respect to the idle position.

According to at least one embodiment of the transducer device, the detector module comprises an emitter configured to emit a radiation. For example, the radiation is in the ultraviolet, visible or near infrared spectral range. For example, the emitter comprises an active region configured to emit the radiation.

For example, the active region is based on a III-V-compound semiconductor material.

III-V compound semiconductor materials are particularly suitable for radiation generation in the ultraviolet spectral range (Alₓ In_{y} Ga_{1-x-y} N) via the visible spectral range (Alₓ In_{y} Ga_{1-x-y} N, in particular for blue to green radiation, or AlₓIn_{y}Ga_{1-x-y}P_{z}As_{1-z}, in particular for green to red radiation) to the infrared spectral range (AlₓIn_{y}Ga_{1-x-y}P_{z}As_{1-z}). Here, 0 ≤ x ≤ 1, 0 ≤ y ≤ 1, 0 ≤ z ≤ 1 and x + y ≤ 1 apply in each case, in particular with x ≠ 1, y ≠ 1, x ≠ 0 and/or y ≠ 0. With III-V compound semiconductor materials, in particular from the material systems mentioned, high internal quantum efficiencies can be achieved in radiation generation.

According to at least one embodiment of the transducer device, the piezoelectric material is transmissive to the radiation.

For example, the so-called PMN-PT materials such as 0.75 Pb(Mg_{1/3}Nb_{2/3})O₃-0.25 PbTiO₃:Pr³⁺ are transmissive to radiation with a wavelength of at least 400 nm. In particular, the material may have a good transmittance in the infrared spectral range such as in a wavelength range from 800 nm to 1 um.

Alternatively, the piezoelectric material may comprise lead titanate zirconate (PZT) or poly(vinylidene fluoride) materials or any other material having sufficient transmittance to the radiation emitted by the emitter.

According to at least one embodiment of the transducer device, the detector module is configured to direct the radiation onto a surface of the piezoelectric material. In particular, the radiation may pass through the entire piezoelectric material along one direction in space.

For example, the surface of the piezoelectric material is a surface that is located on a side of the piezoelectric material that faces away from the detector module.

Thus, the beam path of the radiation from the emitter to the surface of the piezoelectric material passes through the piezoelectric material.

According to at least one embodiment of the transducer device, the detector module is configured to detect a displacement of the surface based on a part of the radiation that is reflected or scattered back to the detector module. In other words, the detector module is configured to perform an optical measurement providing information on the displacement of the surface of the piezoelectric material.

In at least one embodiment of the transducer device, the transducer device comprises a piezoelectric material wherein the transducer device comprises a detector module with an emitter configured to emit radiation. The piezoelectric material is transmissive to the radiation. The detector module is configured to direct the radiation onto a surface of the piezoelectric material. The detector module is configured to detect a displacement of the surface based on a part of the radiation that is reflected or scattered back to the detector module.

By means of the detector module, an optical measurement can be performed to obtain information on the actual displacement of the surface during operation of the transducer device. This may help to compensate for a non-linear behaviour of the piezoelectric material. This can be obtained with a very compact setup, in particular compared to transducers using external sensors that measure the displacement mechanically.

According to at least one embodiment of the transducer device, the emitter comprises a cavity (or resonator). In particular, the emitter is configured to emit coherent radiation. For example, the emitter is a laser such as a surface emitting laser like a vertical cavity surface emitting laser (VCSEL) or an edge emitting laser.

According to at least one embodiment of the transducer device, the detector module is configured to detect the displacement based on a part of the radiation that is coupled back into the cavity of the emitter.

The radiation coupled back into the cavity of the emitter may interfere with the radiation propagating in the cavity of the emitter during operation. A detection relying on this effect is also referred to as self-mixing interferometry (SMI).

According to at least one embodiment of the transducer device, the detector module is configured to provide a self-mixing interferometry signal by monitoring an electric operation parameter of the emitter. For example, the electric operation parameter is a voltage between the contacts of the emitter. The interference effects within the cavity result in a modulation of the electric operation parameter such as the voltage or the current.

According to at least one embodiment of the transducer device, the detector module comprises a detector configured to optically detect a self-mixing interferometry signal. For example, the detector comprises a photosensitive area configured to convert the impinging radiation into an electrical signal. For example, the detector is a photodiode based on a semiconductor material such as silicon. Other semiconductor materials may also be used, for example the III-V compound semiconductor materials mentioned above in connection with the emitter.

A part of the radiation impinging onto the detector allows to obtain information on the displacement of the surface of the piezoelectric material.

For example, the detector is arranged outside of a direct optical beam path from the emitter to the surface of the piezoelectric material. For example, the detector is arranged laterally beside the emitter. Alternatively, the detector may overlap with the emitter in a top view onto the transducer device. For example, the detector and the emitter may be formed in a common semiconductor chip.

According to at least one embodiment of the detector module, the detector module is configured to measure a value of the displacement based on interference fringes occurring during the displacement. By counting the number of interference fringes occurring during the displacement, the displacement can be derived with an accuracy on the order of magnitude of the wavelength of the radiation. Advanced readout techniques even allow accuracy in the nanometer or sub-nanometer range to be obtained. Further, an analysis of the shape of the signal may be used to derive the direction of the displacement. Thus, a compression of the dielectric material can be distinguished from an expansion.

According to at least one embodiment of the transducer device, a reflective layer that is reflective to the radiation is arranged on the surface. Radiation impinging onto the surface of the piezoelectric material may be reflected back at the reflective layer towards the detector module. Further, the reflective layer may reduce the amount of the radiation exiting the transducer device and/or the amount of ambient radiation reaching the detector module.

The reflective layer may directly adjoin the surface of the piezoelectric material. Alternatively, an interlayer transmissive to the radiation may be arranged between the surface and the reflective layer.

For example, the reflective layer comprises a metal layer. A metal layer may provide a high reflectivity over a comparably large spectral range.

Alternatively or in addition, the reflective layer may be configured as a narrow band reflective layer or as a dichroic mirror.

For example, the reflective layer may comprise a dielectric layer stack where adjacent layers mutually differ from one another with respect to its refractive index so that the transmission and reflection properties of the dielectric layer stack can be tuned using optical interference effects occurring at the interfaces of the dielectric layer stack.

According to at least one embodiment of transducer device, the transducer device comprises an optical element arranged in a beam path between the emitter and the surface of the piezoelectric material. For example, the optical element is a lens, a beam splitter, a prism, or a mirror.

According to at least one embodiment of the transducer device, the transducer device is configured for a haptic user interface. For example, the haptic user interface is a part of a display or of any other surface that is intended to provide an interaction with a user.

According to at least one embodiment of the transducer device, the transducer device is configured for a friction modulation device. Such a device may be used to modulate the tactile perception of a user's finger by vibrating the surface ultrasonically. Even though the user cannot perceive the ultrasonic vibration of the surface itself, the friction between the surface and the finger can be reduced.

According to at least one embodiment of the transducer device, the transducer device is configured for energy harvesting, exploiting mechanical energy from an environment of the transducer device. For example, wasted energy may be recovered by the transducer device. For example, the transducer device is configured for a self-energy harvesting touchscreen or a robotic device such as an invisible robotic device.

According to at least one embodiment of the transducer device, the transducer device is configured for monitoring of a user's movement. For example, human movements such as hopping, running or walking may be monitored in real time. Alternatively or in addition, a gait may be monitored.

However, the transducer device may also be used in other applications such as resonators, microphones or instrumentation. For example, the transducer device may be used in consumer electronics, automotive applications, industrial applications, or medical applications.

Further a transducer module is specified. According to at least one embodiment of the transducer module, the transducer module comprises a plurality of transducer devices as described above. For example, the transducer devices are arranged laterally side-by-side so that the transducer module provides a spatial resolution. For example, the plurality of transducer devices of the transducer module are arranged on a common substrate such as a circuit broad or a glass plate.

Further, a method of operating a transducer device comprising a piezoelectric material is specified.

According to at least one embodiment of the method, the method comprises a step of providing the piezoelectric material with a surface, a step of directing radiation of an emitter of a detector module onto the surface and a step of detecting a displacement of the surface based on a part of the radiation that is reflected or scattered back to the detector module.

Thus, the actual displacement of the surface of the piezoelectric material during operation of the transducer device can be monitored by an optical measurement. Non-linear effects of the piezoelectric material can be compensated for based on the obtained information on the displacement of the surface.

According to at least one embodiment of the method, a self-mixing interferometry signal is detected. Thus, the radiation coupled back into a cavity of the emitter can be used to obtain information on the displacement of the surface of the piezoelectric material. Self-mixing interferometry allows a high accuracy of optical measurements with a compact setup to be obtained.

According to at least one embodiment of the method, a control voltage signal applied to the piezoelectric material is set based on the self-mixing interferometry signal. Thus, the self-mixing interferometry signal may be used as an optical feedback signal to precisely control the displacement of the surface.

In particular, the method can be performed using a transducer device as described above. The features described in connection with a transducer device may also apply for the method and vice versa.

Features described above in connection with at least one embodiment of the method or the transducer device can be combined with other features described in connection with at least one embodiment of the method or the transducer device unless they are contradictory.

Further features will become apparent from the subsequent description of the exemplary embodiments in connection with the figures.

In the exemplary embodiments and figures similar or similarly acting constituent parts are provided with the same reference signs. Generally, only the differences with respect to the individual exemplary embodiments are described. Unless specified otherwise, the description of a part or feature in one exemplary embodiment applies to a corresponding part or feature in another exemplary embodiment as well.

In the Figures:
Figure 1A shows an exemplary embodiment of a transducer device in a schematic cross-sectional view;
Figures 1B, 1C and 1D show exemplary embodiments of a detector module for a transducer device as illustrated in Figure 1A;
Figure 2 shows an exemplary embodiment of a transducer device in a schematic cross-sectional view;
Figure 3 shows an exemplary embodiment of a transducer device in a schematic cross-sectional view;
Figure 4 shows an exemplary embodiment of a transducer module in a schematic cross-sectional view; and
Figure 5 shows an exemplary embodiment of a method of operating a transducer device.

The figures are schematic representations. Elements illustrated in the figures and their size relationships among one another are not necessarily true to scale. Rather, individual elements or layer thicknesses may be represented with an exaggerated size for the sake of better representability and/or for the sake of better understanding.

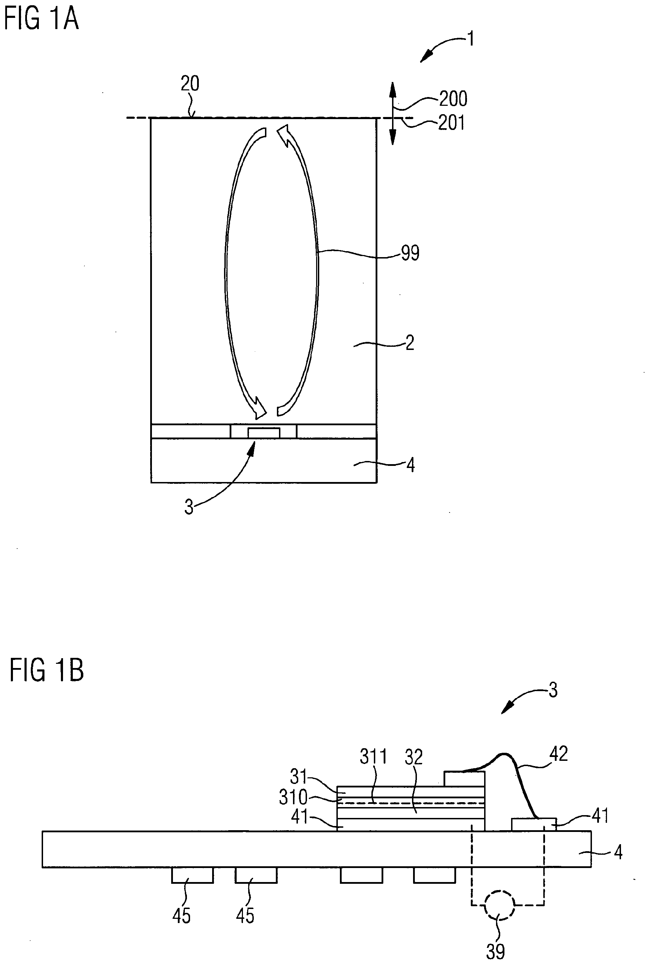

The transducer device 1 illustrated in Figure 1A comprises a piezoelectric material 2 and a detector module 3 comprising an emitter 31 configured to emit radiation. The piezoelectric material 20 is transmissive to the radiation. In Figure 1A arrows illustrate radiation 99 emitted by the emitter and reflected at a surface 20 of the piezoelectric material back towards the detector module 3.

The detector module 3 is configured to detect a displacement 200 of the surface 20 based on a part of the radiation 99 that is reflected or scattered back to the detector module 3. The surface 20 is arranged on a side of the piezoelectric material 2 that faces away from the detector module 3. Thus, the radiation 99 passes through the piezoelectric material 2 on its way to the surface 20 and back to the detector module.

For example, a PMN-PT material such as 0.75 Pb(Mg_{1/3}Nb_{2/3})O₃-0.25 PbTiO₃:Pr³⁺, lead titanate zirconate (PZT), or a poly(vinylidene fluoride) material, or any other material having sufficient transmittance to the radiation emitted by the emitter 31 can be used as piezoelectric material 20.

During operation of the transducer device 1, the displacement 200 of the surface 20 with respect to an idle position 201 may be detected optically by means of the part of the radiation that is impinging onto the detector module 3 after having passed the piezoelectric material 2.

The displacement 200 may be caused by an electrical voltage applied to the piezoelectric material or by a mechanical force exerted onto the piezoelectric material 2.

As illustrated in Fig. 1A, the detector module 3 may be embedded in the piezoelectric material 2. For example, the piezoelectric material 20 laterally surrounds the detector module 3 at least in regions.

Exemplary embodiments of the detector module 3 are illustrated in Figures 1B to 1D.

In the exemplary embodiment of Figure 1B the detector module 3 comprises an emitter 31 with a cavity 310. An active region 311 is arranged within the cavity and configured to emit coherent radiation. The active region may be based on a III-V-compound semiconductor material such as AlInGaAsP.

For example, the emitter 31 is a surface-emitting semiconductor laser such as a vertical cavity surface-emitting laser (VCSEL). Alternatively, an edge-emitting semiconductor laser may be used as emitter 31.

Radiation 99 that is coupled back into the cavity 310 of the emitter 31 may optically interfere with the radiation propagating within the cavity 310 so that self-mixing interference effects occur.

In the exemplary embodiment of Figure 1B, the self-mixing interferometry signal is obtained by monitoring an electric operation parameter of the emitter 31. For instance, a voltmeter 39 is used to monitor the electrical voltage between contacts 32 of the emitter 31 during operation of the transducer device 1. Alternatively the current through the emitter 31 may be monitored.

During the displacement 200 of the surface 20 of the piezoelectric material 2, interference fringes occur that result in local maxima and local minima of the monitored emitter operation parameter such as the voltage. By counting the interference fringes occurring during the displacement 200, the relative displacement of the surface 20, for example with respect to the idle position 201 of the surface 20, of the piezoelectric material 2 can be obtained with an accuracy on the order of the wavelength of the radiation 99 emitted by the emitter 31.

If for example, the displacement of the surface is on the order of a few 100 µm and the wavelength is about 1 µm, counting the interference fringes enables a closed loop operation with a linearity on the order of 0.1%.

If required, the accuracy can be further increased by employing more complicated evaluation algorithms resulting in an accuracy of a few nm or even below 1 nm.

For example, a peak emission wavelength of the emitter 31 is in the near infrared spectral range, in particular in a range from 800 nm to 1.2 um. Radiation in this spectral range is particularly suited as it is invisible to the human eye.

The piezoelectric material 20 mentioned above exhibits a high transmissivity in the near infrared spectral range.

However, radiation in the visible spectral range or in the ultraviolet spectral range may also be used.

In the exemplary embodiment of Figure 1B the emitter 31 is arranged on a connection area 41 of a substrate 4. For example, the substrate 4 is a printed circuit board. The contact 32 of the emitter 31 facing away from the substrate 4 is connected to a connection area 41 of the substrate 4 via a connecting line 42 such as a bonding wire. The detector module 3 and/or the substrate 4 may comprise further electronic devices such as an application specific integrated circuit (ASIC), a processor, or a controller.

On a side of the substrate that faces away from the emitter 31, the detector module 3 comprises terminals 45 for an external electric connection of the detector module 3 or of the entire transducer device 1. For example, the detector module 3 or the transducer device 1 is configured as a surface-mounted device (SMD).

As the self-mixing interferometry signal is obtained in the exemplary embodiment of Figure 1B by monitoring an electric operation parameter of the emitter 31, a single optoelectronic device is sufficient, namely emitter 31.

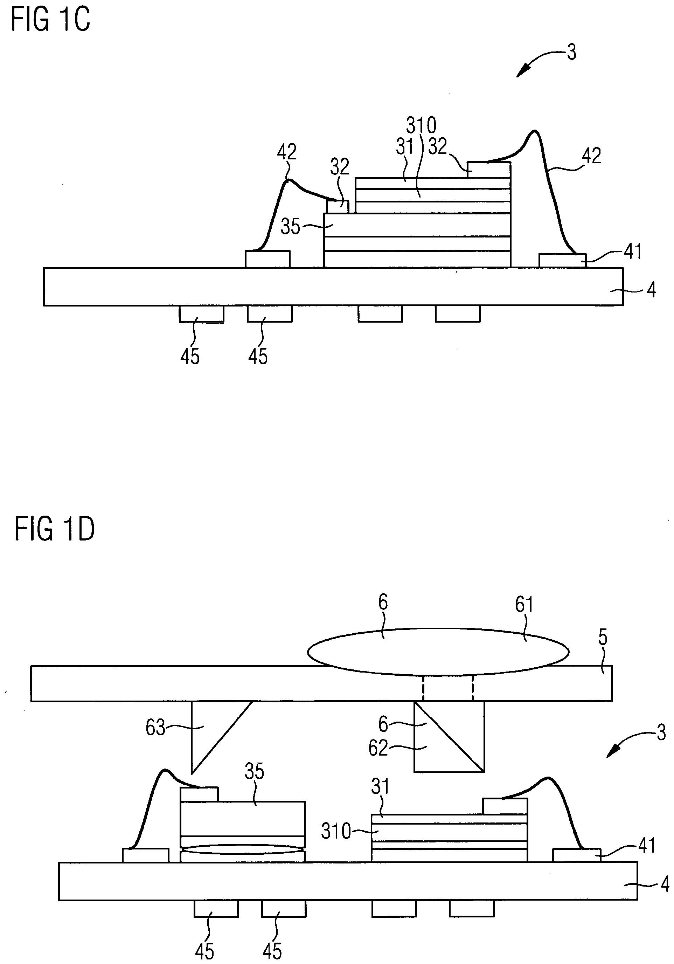

Alternatively, the self-mixing interferometry signal may also be obtained via a detector 35. This is illustrated in Figures 1C and 1D.

In the exemplary embodiment of Figure 1C, the detector 35 is arranged on a side of the emitter 31 that faces away from the surface 20 of the piezoelectric material 2. For example, a mirror of the cavity 310 that faces away from the piezoelectric material 2 is configured to transmit a part of the radiation propagating in the cavity.

The emitter 31 and the detector 35 may be produced on the same semiconductor chip or be produced on different semiconductor chips stacked one above the other.

In the exemplary embodiment of Figure 1D, the detector 35 is arranged laterally beside the emitter 31 on the substrate 4. A beam splitter 62 is arranged in a beam path from the emitter 31 towards the surface 20. A portion of the emitted radiation is directed via a mirror 63 towards the detector 35 so that a self-mixing interferometry signal can be detected optically by means of the detector.

In this exemplary embodiment two optical elements 6, namely the beam splitter 62 and a lens 31 are arranged in a beam path of the radiation 99 from the emitter 31 to the surface 20 and back. Such optical elements may also be used in the exemplary embodiments described above if appropriate.

In the exemplary embodiment of Figure 1D, the optical elements 6 are arranged on a carrier 5. The carrier may be the same carrier that supports the piezoelectric material 2 or an additional carrier.

The substrate 4 and/or the carrier 5 may be transmissive or opaque to the radiation 99. If the carrier 5 is opaque, the carrier 5 may comprise a cutout, so that the radiation may pass through the cutout towards the surface 20 and back.

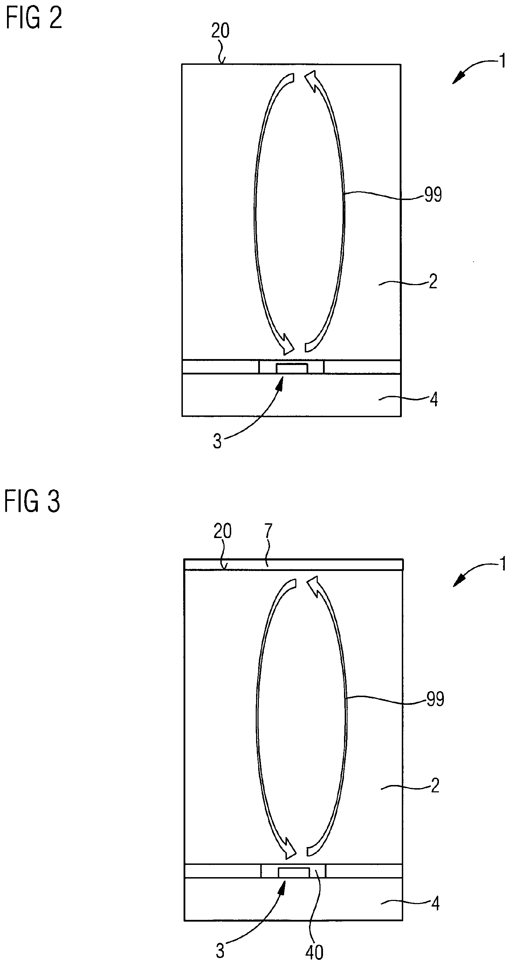

The exemplary embodiment of Figure 2 substantially corresponds to the exemplary embodiment described in connection with Figures 1A to 1D.

In departure therefrom, the detector module 3 is not embedded in the piezoelectric material 2 but rather the emitter is embedded in the substrate 4.

For example, the substrate 4 comprises a recess 40 configured to receive the detector module 3.

The exemplary embodiment illustrated in Figure 3 substantially corresponds to the exemplary embodiment illustrated in Figure 2. In departure therefrom a reflective layer 7 is arranged on the surface 20 of the piezoelectric material. For example, the reflective layer 7 is a metal layer or a dielectric layer stack configured to at least reflect the radiation 99 emitted by the emitter 31.

Alternatively or in addition, the reflective layer 7 may be embodied as a dichroic mirror.

A reflective layer 7 as shown in Figure 3 may also be used for the other exemplary embodiments of the transducer device 1.

By means of the reflective layer 7 external disturbances, such as reflections at a user's body parts, such as fingers can be reduced.

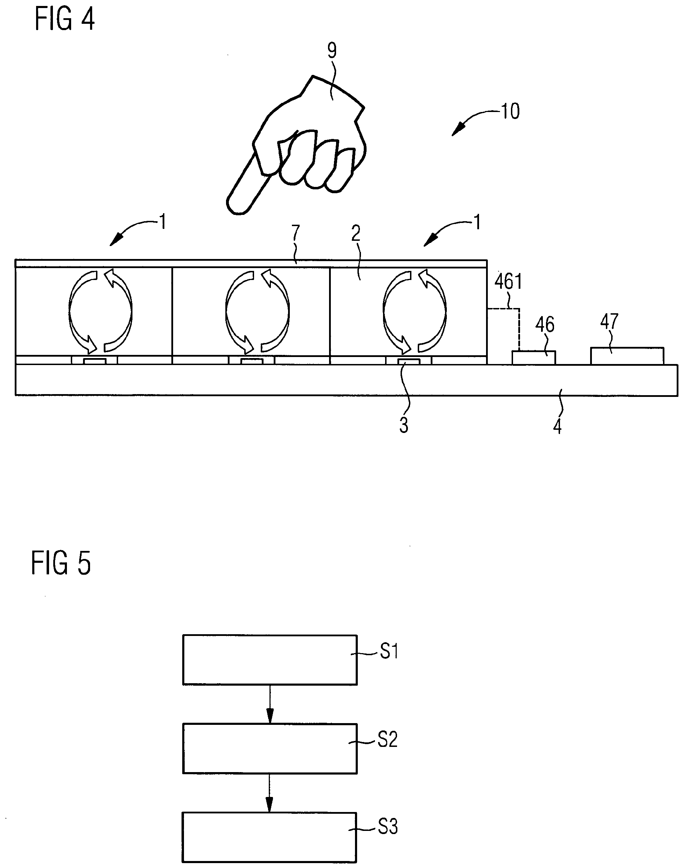

Figure 4 illustrates an exemplary embodiment of a transducer module 10 comprising a plurality of transducer devices 1.

In the exemplary embodiment illustrated in Figure 4, the individual transducer devices 1 are configured as described in connection with Figure 3. The transducer devices 1 are arranged laterally side-by-side on a common substrate 4 to provide a spatial resolution.

Figure 4 further illustrates a controller 46 and a processor 47 as examples of electronic components provided in the transducer device 1 or the transducer module 10. Such electronic components may also be used for the exemplary embodiments described above.

For example, the controller 46 is configured to apply a control voltage 461 to the piezoelectric material 2 of the individual transducer devices 1. Based on the displacement measured by the detector module 3, the applied control voltage 461 can be set such that the intended displacement of the surface 20 is obtained.

For example, the transducer devices 1 or the transducer module 10 are configured for a haptic user interface. For example, the haptic user interface may provide a haptic feedback. For example, the user interface is a surface of a display screen or any other surface intended for an interaction with a user 9.

The transducer devices 1 or the transducer module 10 may also be configured for a friction modulation device where forces at the interface between a finger of the user 9 and the transducer device 1 are modulated by an ultrasonic vibration of the surface 20.

Alternatively or in addition, the transducer device 1 or the transducer module 10 may be configured for energy harvesting exploiting a mechanical energy from an environment of the transducer device 1.

Further, the transducer device 1 may also be configured for monitoring external movements of the transducer device.

For example, the transducer device may be configured for monitoring a user's movement. For example, a real time monitoring of human movement such as hopping, running or walking can be performed. Alternatively or in addition, a gait may be analysed.

In addition, the transducer device 1 or the transducer module 10 may also be used for other applications using piezoelectric material, in particular if a high accuracy of the displacement 200 is required.

For example, the transducer device 1 may be used in a resonator or in a microphone or in other devices, in particular the transducer device or the transducer module may be used in consumer electronic devices, automotive applications, medical applications or industrial applications.

Figure 5 illustrates a method of operating a transducer device comprising a piezoelectric material. For easier understanding, the structural features are provided with the same reference numerals as in the previous exemplary embodiments even if their reference numerals are not explicitly shown in Figure 5.

In a step S1, the piezoelectric material 20 with a surface 20 is provided. In a step S2, radiation 99 of an emitter 31 of a detector module 3 is directed onto the surface 20. In a step S3, a displacement 200 of the surface 20 is detected based on a part of the radiation 99 that is reflected or scattered back to the detector module.

In particular, the displacement 200 can be detected using a self-mixing interferometry signal caused by radiation that is coupled back into a cavity 310 of the emitter 31.

For example, a control voltage 461 applied to the piezoelectric material 20 can be set based on the self-mixing interferometry signal obtained from the detector module 3.

In particular, the method can be performed using a transducer device 1 or transducer module 10 configured as described in connection with the exemplary embodiments above.

The invention described herein is not restricted by the description given with reference to the exemplary embodiments. Rather, the invention encompasses any novel feature and any combination of features, including in particular any combination of features in the claims, even if this feature or this combination is not itself explicitly indicated in the claims or exemplary embodiments.

### References

- 1: transducer device
- 10: transducer module
- 2: piezoelectric material
- 20: surface
- 200: displacement
- 201: idle position
- 3: detector module
- 31: emitter
- 310: cavity
- 311: active region
- 32: contact
- 35: detector
- 39: voltmeter
- 4: substrate
- 40: recess
- 41: connection area
- 42: connecting line
- 45: terminal
- 46: controller
- 461: control voltage
- 47: processor
- 5: carrier
- 6: optical element
- 61: lens
- 62: beam splitter
- 63: mirror
- 7: reflective layer
- 9: user
- 99: radiation
- S1,S2,S3: step

## Claims

1. A transducer device (1) comprising a piezoelectric material (2), wherein
- the transducer device comprises a detector module (3);
- the detector module (3) comprises an emitter (31) configured to emit a radiation (99);
- the piezoelectric material (2) is transmissive to the radiation (99);
- the detector module (3) is configured to direct the radiation onto a surface (20) of the piezoelectric material (2) ; and
- the detector module (3) is configured to detect a displacement (200) of the surface (20) based on a part of the radiation (99) that is reflected or scattered back to the detector module (3).

2. The transducer device according to claim 1,
wherein the emitter (31) comprises a cavity (310), and
wherein the detector module (3) is configured to detect the displacement based on a part of the radiation (99) that is coupled back into the cavity (310) of the emitter (31).

3. The transducer device according to claim 1 or 2,
wherein the detector module (3) is configured to provide a self-mixing interferometry signal by monitoring an electric operation parameter of the emitter (31).

4. The transducer device according to any one of the preceding claims,
wherein the detector module (3) comprises a detector configured to optically detect a self-mixing interferometry signal.

5. The transducer device according to any one of the preceding claims,
wherein the detector module (3) is configured to measure a value of the displacement (200) based on interference fringes occurring during the displacement (200).

6. The transducer device according to any one of the preceding claims,
wherein a reflective layer that is reflective to the radiation is arranged on the surface (20) of the piezoelectric material (2).

7. The transducer device according to any one of the preceding claims,
wherein the transducer device (1) is configured for a haptic user interface.

8. The transducer device according to any one of the preceding claims,
wherein the transducer device (1) is configured for a friction modulation device.

9. The transducer device according to any one of the preceding claims,
wherein the transducer device (1) is configured for energy harvesting exploiting a mechanical energy from an environment of the transducer device (1).

10. The transducer device according to any one of the preceding claims,
wherein the transducer device (1) is configured for monitoring of a user's movement.

11. A transducer module (1) comprising a plurality of transducer devices (1) according to any one of the preceding claims arranged laterally side by side.

12. A method of operating a transducer device comprising a piezoelectric material (2), comprising the steps of:
a) providing the piezoelectric material (2) with a surface (20);
b) directing radiation of an emitter of a detector module (3) onto the surface (20);
c) detecting a displacement (200) of the surface (20) based on a part of the radiation that is reflected or scattered back to the detector module (3).

13. The method according to claim 12,
wherein a self-mixing interferometry signal is detected in step c).

14. The method according to claim 12 or 13,
wherein a control voltage signal applied to the piezoelectric material (2) is set based on the self-mixing interferometry signal.

15. The method according to any one of claims 12 to 14 wherein the method is performed using a transducer device (1) according to any one of claims 1 to 10.
